# EUROPEAN PATENT APPLICATION

(11) **EP 3 434 389 A1**
(43) Date of publication of application: **30.01.2019**
(21) Application number: 18185816.8
(22) Date of filing: 26.07.2018
(51) Int. Cl.: B22C 7/02, B22C 9/04

(54) **THIN-WALLED HEAT EXCHANGER WITH IMPROVED THERMAL TRANSFER FEATURES**

(30) Priority: 27.07.2017 US 201715661439
(71) Applicant: United Technologies Corporation, Farmington, CT 06032 (US)
(72) Inventor: TWELVES, Wendell V. Jr., Glastonbury, CT 06033 (US); ALFORD, William E., Wallingford, CT 06492 (US)
(74) Representative: Dehns

(57) **Abstract**

A thin-walled heat exchanger includes a component (10) having at least one thermal transfer structure (12). The thermal transfer structure (12) includes a wall (20) having a thickness ranging from about 0.003 in (0.076 mm) to about 0.010 in (0.254 mm).

## Description

### BACKGROUND

Heat exchanger efficiency can be increased by designing ultra-thin heat transfer surfaces with smooth surface finishes. Powder-based and wire-feed additive manufacturing processes can be used to produce heat exchanger components, but the resultant components can suffer from porosity, irregular wall thicknesses, and poor surface finish due to process limitations. Thus, the need exists for a cost-effective means of producing thin-walled heat exchanger components with smooth surface finishes.

### SUMMARY

A thin-walled heat exchanger includes a component having at least one thermal transfer structure. The thermal transfer structure includes a wall having a thickness ranging from about 0.003 in (0.076 mm) to about 0.010 in (0.254 mm).

A method of forming a component of a heat exchanger includes producing, using a 3D printing process, a sacrificial body from a polymer material. The sacrificial body has a shape corresponding to a shape of the component. The method further includes selectively coating a first surface of the sacrificial body with a metallic material to form a thermal transfer wall, and removing the portion of the sacrificial body beneath the thermal transfer wall.

Features of embodiments are set forth in the dependent claims.

### BRIEF DESCRIPTION OF THE DRAWINGS

FIG. 1 is a perspective view of a heat exchanger component.
FIG. 2 is a cross-section of a heat exchanger component according to the embodiment of FIG. 1.
FIG. 3 is a cross-section of the heat exchanger component attached to manifolds.
FIG. 4 is a cross-section of an alternative heat exchanger component having integral manifolds.

### DETAILED DESCRIPTION

A method of forming a thin-walled heat exchanger is described herein. The method includes forming a sacrificial structure using a 3D polymer printing process, and selectively coating the sacrificial structure with a metallic material. The sacrificial structure can be removed to leave behind a metallic component having thin walls, minimal porosity, and a smooth surface finish. The thin walls allow for increased heat transfer between heat exchanger fluids without compromising structural integrity.

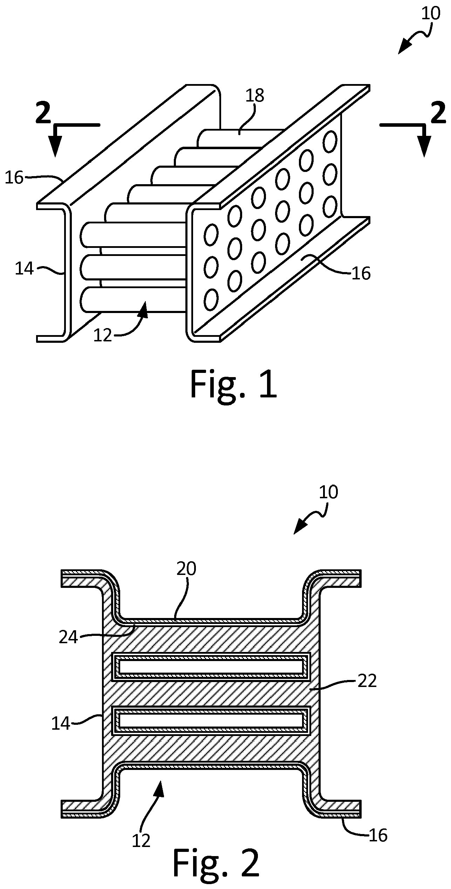

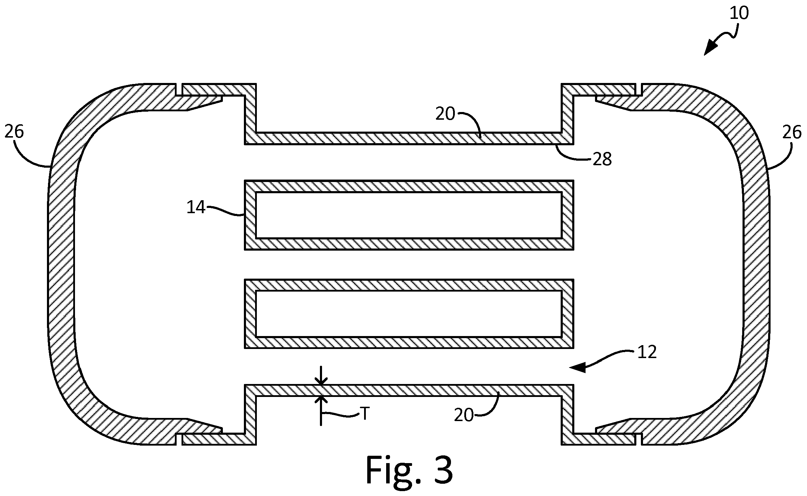

FIG. 1 is a perspective view of heat exchanger component 10. Component 10 includes tubes 12, bulkheads 14, and flanges 16. As is known in the art, component 10 is configured such that a first fluid flows through an interior surface (shown in FIG. 3) of tubes 12, while a second fluid having a different starting temperature than the first fluid flows perpendicularly across an exterior surface 18 of tubes 12. Therefore, walls 20 (shown in FIG. 2) of tubes 12 act as thermal transfer surfaces as heat is transferred from the first fluid to the second fluid, or vice versa, through walls 20.

FIG. 2 is a cross-section of component 10 taken along line 2 of FIG. 1. In the embodiment shown, walls 20 of tubes 12 are formed upon sacrificial body 22, designed to have the same geometry ultimately desired in tubes 12. Body 22 can be formed from a polymer material such as polylactic acid (PLA), acrylonitrile-butadiene-styrene (ABS), and nylon, to name a few, non-limiting examples. Other suitable polymers are contemplated herein. Body 22 can be formed using any suitable 3D polymer printing process, such as a vat photopolymerization process.

Body 22 is coated with a metal or metal alloy to form walls 20 of tubes 12. Suitable coating materials include copper, nickel, nickel-cobalt, nickel-phosphorus, nickel-boron, nickel-tungsten, and nickel-chromium. The coating of body 22 can be accomplished using a plating process such as electroless plating, electroplating, carbonyl plating, chemical vapor deposition, and physical vapor deposition. Prior to coating, outer surface 24 of body 22 can optionally be treated with acetone vapor to create a smooth surface finish.

In the embodiment shown, the regions of body 22 corresponding to bulkheads 14 can be masked during coating so that body 22 is not completely coated with the metal material. This facilitates the subsequent removal of body 22 from component 10. The removal of body 22 can be accomplished by heating the polymer and draining the resulting liquid polymer from openings within the formed component. The removal of body 22 can also be accomplished using a chemical method, such as exposing body 22 to an acid or a polymer-dependent solvent to dissolve the polymer material. In other embodiments, it may also be desirable to leave some or all of body 22 in place beneath the metal coating. After body 22 is removed, component 10 can undergo a secondary coating process to form bulkheads 14.

FIG. 3 is a cross-section of component 10 attached to manifolds 26 after the removal of body 22 (shown in FIG. 2). In the embodiment shown, manifolds 26 are formed using traditional or additive manufacturing techniques. Component 10 can be attached to manifolds 26 using techniques such as brazing or welding, depending on the materials used to form component 10 and manifolds 26. Because coating on sacrificial body 22 allows for the close control of the geometry of flanges 16 (shown in FIG. 2), tight-fight braze joints can be formed.

Walls 20 can have a thickness T ranging from 0.003 in to 0.010 in (76 µm to 254 µm). In other embodiments, walls 20 can have a thickness T as low as 0.0005 in (12.7 µm). Inner surfaces 28 of walls 20 have a smooth surface finish, as inner surfaces 28 are essentially mirror images of the smooth, outer surface 24 (shown in FIG. 2) of body 22. In the embodiment shown, thickness T is generally uniform throughout component 10. In other embodiments, however, areas such as bulkheads 14 or flanges 16 can be made thicker than walls 20 based on design or structural requirements. This local thickening can be performed while coating on sacrificial body 22, or during a secondary coating process. In some embodiments, walls 20 can also include locally thickened portions.

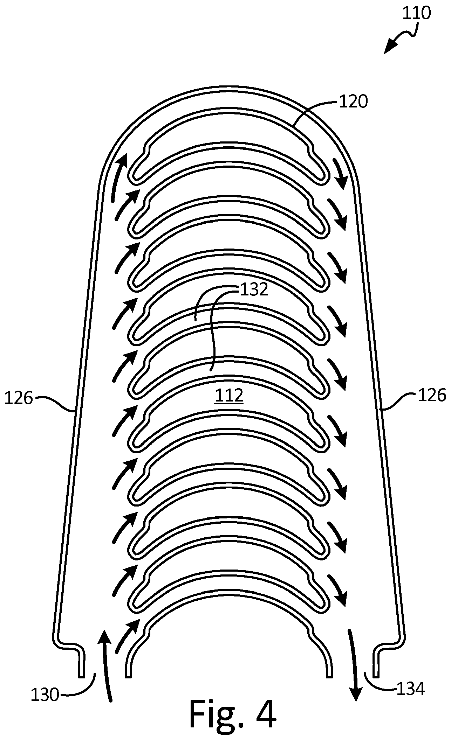

FIG. 4 is a cross-section of alternative component 110 having integral manifolds 126. Component 110 is formed entirely on a sacrificial body (not shown in FIG. 4) having corresponding geometries. In the embodiment shown in FIG. 4, a fluid (denoted by arrows) enters through supply port 130, flows across manifold passages 132 and out through return port 134. As can be seen in FIG. 4, the entry angle of the fluid flow into passages 132 is less than 90° which reduces fluid flow turbulence and associated pressure loss within component 110. Other suitable angles are also contemplated herein. Tubes 112 are shown perpendicular to passages 132, and are configured to receive a fluid flow in such direction. Walls 120 can be formed to have a thickness falling within the same range as thickness T of walls 20. In this regard, component 110 offers low loss flow alignment within manifolds 126 and improved thermal transfer across walls 120.

The disclosed heat exchanger components offer improved performance over heat exchangers of the prior art. Sacrificial templating allows for the formation of relatively thin and structurally sound heat transfer surfaces. The surfaces, as formed, have reduced porosity and improved surface finish. Sacrificial mandrels can be formed to have various shapes and geometries in order to produce a highly customized component. Additional enhancements to walls, bulkheads, or interface features can also include ribs, trip strips, corrugations, spiral grooves, stiffening beads, local constrictions or expansions, and bypass ports. Resulting components can be included in heat exchangers used in turbine engines, computers, electronics, industrial processes, and more. Components can also be used in radiators, oil cooling systems, fuel cooling systems, air cooling systems, flow control manifolds, and fluid/resin distribution manifolds.

### Discussion of Possible Embodiments

The following are non-exclusive descriptions of possible embodiments of the present invention.

A thin-walled heat exchanger includes a component having at least one thermal transfer structure. The thermal transfer structure includes a wall having a thickness ranging from about 0.003 in (76 µm) to about 0.010 in (254 µm).

The heat exchanger of the preceding paragraph can optionally include, additionally and/or alternatively, any one or more of the following features, configurations and/or additional components:
The at least one thermal transfer structure includes a tube.

The component is attached to a manifold.

The component is attached to the manifold using a brazing or welding technique.

The component includes an integral manifold.

The component if formed from a material selected from the group consisting of copper, nickel, nickel-cobalt, nickel-phosphorus, nickel-boron, nickel-tungsten, nickel-chromium, and combinations thereof.

The component includes at least one bulkhead structure.

The component includes an opening within the bulkhead structure or the thermal transfer structure, the opening configured to drain a sacrificial body material.

The component includes a plurality of thermal transfer structures.

A method of forming a component of a heat exchanger includes producing, using a 3D printing process, a sacrificial body from a polymer material. The sacrificial body has a shape corresponding to a shape of the component. The method further includes selectively coating a first surface of the sacrificial body with a metallic material to form a thermal transfer wall, and removing the portion of the sacrificial body beneath the thermal transfer wall.

The method of the preceding paragraph can optionally include, additionally and/or alternatively, any one or more of the following features, configurations and/or additional components:
The method includes treating the surface of the sacrificial body with acetone vapor prior to the coating step.

The method includes coating a second surface of the sacrificial body with the metallic material to form a bulkhead structure.

The thermal transfer structure comprises a wall having a thickness ranging from about 0.003 in (76µm) to about 0.010 in (254 µm).

The bulkhead structure has a thickness greater than the thickness of the wall.

The polymer material has a lower melting temperature than the metallic material.

The polymer material is selected from the group consisting of polylactic acid, acrylonitrile-butadiene-styrene, nylon, and combinations thereof.

The metallic material is selected from the group consisting of copper, nickel, nickel-cobalt, nickel-phosphorus, nickel-boron, nickel-tungsten, nickel-chromium, and combinations thereof.

The step of producing the sacrificial body includes a vat photopolymerization process.

The step of selectively coating a first surface of the sacrificial body includes a plating process selected from the group consisting of electroless plating, electroplating, carbonyl plating, chemical vapor deposition, physical vapor deposition, and combinations thereof.

The removing step includes thermal or chemical dissolution.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A thin-walled heat exchanger comprising:
a component (10;110) having at least one thermal transfer structure (12;112);
wherein the thermal transfer structure (12;112) comprises a wall (20;120) having a thickness ranging from about 0.003 in (0.076 mm) to about 0.010 in (0.254 mm).

2. The heat exchanger of claim 1, wherein the at least one thermal transfer structure (12;112) comprises a tube (12;112).

3. The heat exchanger of claim 1 or 2, wherein the component (10) is attached to a manifold (26), optionally using a brazing or welding technique.

4. The heat exchanger of claim 1 or 2, wherein the component (110) comprises an integral manifold (126).

5. The heat exchanger of any preceding claim, wherein the component (10;110) is formed from a material selected from the group consisting of copper, nickel, nickel-cobalt, nickel-phosphorus, nickel-boron, nickel-tungsten, nickel-chromium, and combinations thereof.

6. The heat exchanger of any preceding claim, wherein the component (10;110) comprises at least one bulkhead structure (14); and optionally an opening within the bulkhead structure (14) or the thermal transfer structure (12;112), the opening configured to drain a sacrificial body material.

7. The heat exchanger of any preceding claim, wherein the component (10;110) comprises a plurality of thermal transfer structures (12;112).

8. A method of forming a component (10;110) of a heat exchanger, the method comprising:
producing, using a 3D printing process, a sacrificial body (22) from a polymer material, the sacrificial body (22) having a shape corresponding to a shape of the component (10;110);
selectively coating a first surface (24) of the sacrificial body (22) with a metallic material to form a thermal transfer wall (20;120); and
removing the portion of the sacrificial body (22) beneath the thermal transfer wall (20;120).

9. The method of claim 8, further comprising treating the surface (24) of the sacrificial body (22) with acetone vapor prior to the coating step.

10. The method of claim 8 or 9, further comprising coating a second surface of the sacrificial body with the metallic material to form a bulkhead structure (14), optionally wherein the bulkhead structure (14) has a thickness greater than the thickness of the wall (20;120).

11. The method of any of claims 8 to 10, wherein the polymer material has a lower melting temperature than the metallic material.

12. The method of any of claims 8 to 11, wherein the polymer material is selected from the group consisting of polylactic acid, acrylonitrile-butadiene-styrene, nylon, and combinations thereof; and/or wherein the metallic material is selected from the group consisting of copper, nickel, nickel-cobalt, nickel-phosphorus, nickel-boron, nickel-tungsten, nickel-chromium, and combinations thereof.

13. The method of any of claims 8 to 12, wherein the step of producing the sacrificial body (22) comprises a vat photopolymerization process.

14. The method of any of claims 8 to 13, wherein the step of selectively coating a first surface (24) of the sacrificial body (22) comprises a plating process selected from the group consisting of electroless plating, electroplating, carbonyl plating, chemical vapor deposition, physical vapor deposition, and combinations thereof.

15. The method of any of claims 8 to 14, wherein the removing step comprises thermal or chemical dissolution.
